# EUROPÄISCHE PATENTSCHRIFT

(11) **EP 3 320 618 B1**
(45) Veröffentlichungstag und Bekanntmachung des Hinweises auf die Patenterteilung: **22.05.2019**
(21) Anmeldenummer: 16742192.4
(22) Anmeldetag: 05.07.2016
(51) Int. Cl.: H03M 1/06, H03M 1/08, H03M 1/36

(54) **FILTERSCHALTUNG ZUR FILTERUNG EINES EINGANGSSIGNALS EINES ANALOG-DIGITAL-WANDLERS**
FILTER CIRCUIT FOR FILTERING AN INPUT SIGNAL OF AN ANALOGUE-TO-DIGITAL CONVERTER
CIRCUIT DE FILTRAGE POUR FILTRER UN SIGNAL D'ENTRÉE D'UN CONVERTISSEUR ANALOGIQUE-NUMÉRIQUE

(30) Priorität: 09.07.2015 DE 102015212848
(43) Veröffentlichungstag der Anmeldung: 16.05.2018
(73) Patentinhaber: Forschungszentrum Jülich GmbH, 52425 Jülich (DE)
(72) Erfinder: GREWING, Christian, 52428 Jülich (DE)
(74) Vertreter: dompatent von Kreisler Selting Werner - Partnerschaft von Patent- und Rechtsanwälten mbB
(86) Internationale Anmeldenummer: PCT/EP2016/065856
(87) Internationale Veröffentlichungsnummer: WO 2017/005745

(56) Entgegenhaltungen:
- WO-A1-99/13583
- US-A- 5 680 265

## Beschreibung

### Gebiet der Erfindung

Die Erfindung bezieht sich auf eine Filterschaltung zur Filterung eines Eingangssignals eines Analog-Digital-Wandlers, einen Analog-Digital-Wandler und ein zugehöriges Verfahren zur Filterung eines Eingangssignals eines Analog-Digital-Wandlers.

### Hintergrund der Erfindung

Ein Analog-Digital-Wandler (ADC) soll zu einem bestimmten, sich wiederholendem Zeitpunkt entscheiden, ob das Eingangssignal oberhalb oder unterhalb einer bestimmten Schwelle lag. Durch eine Mehrzahl von Schwellen entsteht so eine digitale Repräsentation des Signales zu jeweils einem Zeitpunkt der Clockperiode. Bei einem herkömmlichen ADC muss das Eingangssignal vor der Wandlung gefiltert werden (Antialiasing Filter). Dabei kann das Eingangssignal durch Rauschen oder Nichtlinearitäten gestört werden. Ein aktives Filter verbraucht zusätzliche Energie. Um ein Schwanken des Abtastzeitpunktes zu vermeiden, ist man zudem bemüht, bei dem Clocksignal möglichst scharfe Flanken zu erzeugen. Diese erzeugen durch parasitäre Kopplungen Störungen auf den internen Signalen des ADC, also zum Beispiel auch auf den Referenzspannungen, mit denen das Eingangssignal verglichen wird. Diese Schwankungen erzeugen Fehlentscheidungen der Komparatoren.

Die WO 99/13583 offenbart in dieser Beziehung ein System und Verfahren zur Korrektur eines Komparator-Offsets, der während des Betriebs eines Analog Digital-Wandlers auftreten.

### Zusammenfassung der Erfindung

Es ist eine Aufgabe der vorliegenden Erfindung, eine verbesserte Filterschaltung insbesondere zur Filterung eines Eingangssignals eines Analog-Digital-Wandlers zur Verfügung zu stellen.

Gemäß eines ersten Aspektes der Erfindung wird eine Filterschaltung zur Filterung eines Eingangssignals insbesondere eines analogen Eingangssignals zur Verfügung gestellt. Die Filterschaltung umfasst mindestens einen ersten Filterstrang. Der erste Filterstrang umfasst eine erste Eingangsschaltung, eine erste Integrationsschaltung und eine erste Ausgangsschaltung. Die erste Eingangsschaltung ist eingerichtet, ein analoges Eingangssignal in Abhängigkeit vom Wert des Eingangssignals in mindestens zwei unterscheidbare, erste erststufige Ausgangssignale umzuwandeln, und die erststufigen Ausgangssignale während eines vorgegebenen Zeitraums an die erste Integrationsschaltung weiterzuleiten. Die erste Integrationsschaltung ist zudem eingerichtet, die ersten erststufigen Ausgangssignale der ersten Eingangsschaltung über den vorgegebenen Zeitraum zu integrieren und ein erstes Integrationssignal zu erzeugen. Die erste Ausgangsschaltung ist eingerichtet, das erste Integrationssignal mit einem ersten Ausgangreferenzwert zu vergleichen und ein erstes zweitstufiges Ausgangssignal zu generieren.

Die Integration vermeidet, dass Veränderungen des Eingangssignals, insbesondere hochfrequente Störungen des Eingangssignals, die kürzer als der vorgegebene Zeitraum sind, keine bzw. nur einen geringfügigen Einfluss auf das Integrationsergebnis haben. Die ersten erststufigen Ausgangssignale sind dabei diskreter Natur. Ein Beispiel für diskrete erste erststufige Ausgangssignale wären die definierten Spannungen am Ausgang eines Komparators, der vergleicht, ob das Eingangssignal oberhalb oder unterhalb einer definierten Referenzspannung liegt. Die ersten erststufigen Ausgangssignale können kontinuierlich oder zeitdiskret ausgegeben werden.

Der erste Filterstrang weist einen ersten Eingangsreferenzwert auf. Der erste Eingangsreferenzwert kann dabei fest vorgegeben oder frei programmierbar sein. Das Eingangssignal wird mit dem ersten Eingangsreferenzwert verglichen, um die ersten erststufigen Ausgangssignale zu bestimmen.

Das Eingangssignal wird durch die Eingangsschaltung in erste erststufige Ausgangssignale umgewandelt, die das Eingangssignal in dieser Ausführungsform in einen definierten Bezug zu dem definierten ersten Eingangsreferenzwert setzen. Zielsetzung dieser Referenzierung des Eingangssignals in dieser Ausführungsform ist es, die ersten erststufigen Ausgangssignale durch den Bezug zu dem definierten ersten Eingangsreferenzwert unterscheidbar zu machen. Die ersten erststufigen Ausgangssignale entsprechen dem Vorzeichen der Differenz des Eingangssignales minus des ersten Eingangsreferenzwertes. Der erste Eingangsreferenzwert weist einen diskreten Wert auf.

Die erste Eingangsschaltung umfasst vorzugsweise zumindest einen Eingangskomparator und die erste Ausgangsschaltung umfasst vorzugsweise mindestens einen Ausgangskomparator.

Die erste Integrationsschaltung weist vorzugsweise zumindest einen ersten Kondensator und erste Schalter auf. Der erste Kondensator und die ersten Schalter sind in dieser Ausführungsform eingerichtet, elektrische Ladungen, die den ersten erststufigen Ausgangssignalen zugeordnet sind über den vorgegebenen Zeitraum zu akkumulieren. Die ersten Schalter werden zum Beispiel so geschaltet dass während des vorgegebenen Zeitraums aufgrund der ersten erststufigen Ausgangssignale Ladungen auf den ersten Kondensator fließen. Die ersten Schalter werden am Ende des vorgegebenen Zeitraums so geschaltet, dass die während des vorgegebenen Zeitraums akkumulierte Ladung auf dem ersten Kondensator als Integrationssignal weitergeleitet bzw. der Ausgangsschaltung zur Verfügung gestellt werden kann. Sobald das Integrationssignal an die Ausgangsschaltung weitergeleitet wurde, werden die ersten Schalter so geschaltet, dass der erste Kondensator entladen wird. In einem nachfolgenden vorgegebenen Zeitraum kann der erste Kondensator wieder geladen werden, um erneut ein Integrationssignal zur Verfügung zu stellen.

Der vorgegebene Zeitraum wird vorzugsweise durch ein erstes regelmäßiges Zeitsignal vorgegeben. Das erste regelmäßige Zeitsignal kann zum Beispiel ein periodisches Clocksignal innerhalb einer Schaltungsanordnung sein. Dieses Clocksignal kann zum Beispiel eine Rechteckform aufweisen, wobei zumindest eine Halbperiode des Clocksignals zur Erzeugung des Integrationssignals verwendet wird.

Der erste Filterstrang weist vorzugsweise eine erste Schaltung zur Zeitdiskreditierung auf. Die erste Schaltung zur Zeitdiskreditierung ist dabei dazu eingerichtet, das erste zweitstufige Ausgangssignal zu verarbeiten und in ein zeitdiskretes Ausgangssignal umzuwandeln. Beispiele für Schaltungen zur Zeitdiskreditierung sind getaktete Flipflops oder Latches. Die erste Schaltung zur Zeitdiskreditierung ist vorzugsweise eingerichtet, das erste zweitstufige Ausgangssignal in Abhängigkeit von dem ersten regelmäßigen, insbesondere periodischen Zeitsignal in das erste zeitdiskrete Ausgangssignal umzuwandeln.

Die Filterschaltung umfasst vorzugsweise mindestens einen zweiten Filterstrang, wobei dem ersten Filterstrang ein erster Bereich des Eingangssignals zugeordnet ist und dem zweiten Filterstrang ein zweiter Bereich des Eingangssignals zugeordnet ist, wobei sich der erste Bereich des Eingangssignals vom zweiten Bereich des Eingangssignals unterscheidet.

Der erste und der zweite Bereich können sich teilweise überlappen. Der zweite Filterstrang umfasst eine zweite Eingangsschaltung, eine zweite Integrationsschaltung und eine zweite Ausgangschaltung. Die zweite Eingangsschaltung erzeugt ein zweites erststufiges Ausgangssignal. Die Integrationsschaltung erzeugt ein zweites Integrationssignal. Die Ausgangsschaltung erzeugt ein zweites zweitstufiges Ausgangssignal. Der erste Filterstrang ist somit eingerichtet, den ersten Bereich des Eingangssignals in der zuvor beschriebenen Art und Weise zu filtern. Der zweite Filterstrang ist somit eingerichtet, den zweiten Bereich des Eingangssignals in der zuvor beschriebenen Art und Weise zu filtern.

Die Filterschaltung umfasst vorzugsweise mindestens einen dritten Filterstrang, wobei dem dritten Filterstrang ein dritter Bereich des Eingangssignals zugeordnet ist, wobei der zweite Bereich des Eingangssignals an den ersten Bereich des Eingangssignals grenzt, und der dritte Bereich des Eingangssignals an den zweiten Bereich des Eingangssignals grenzt. Der dritte Filterstrang umfasst eine dritte Eingangsschaltung, eine dritte Integrationsschaltung und eine dritte Ausgangschaltung. Die dritte Eingangsschaltung erzeugt ein drittes erststufiges Ausgangssignal. Die Integrationsschaltung erzeugt ein drittes Integrationssignal. Die dritte Ausgangsschaltung erzeugt ein drittes zweitstufiges Ausgangssignal. Der dritte Filterstrang ist somit eingerichtet, den dritten Bereich des Eingangssignals in der zuvor beschriebenen Art und Weise zu filtern. Die Filterschaltung kann weitere Filterstränge (4, 5, 6 oder mehr) aufweisen, so dass dem Eingangssignal mittels der Filterstränge eine Vielzahl von zweitstufigen Ausgangssignalen bzw. zeitdiskreten Ausgangssignalen zugewiesen werden kann.

Der erste Bereich, der zweite Bereich, der dritte Bereich und weitere Bereiche des Eingangssignals sind vorzugsweise gleich groß. Das Eingangssignal kann somit in eine Vielzahl von gleichgroßen Bereichen aufgeteilt werden, für die die zweitstufigen Ausgangssignale bzw. zeitdiskreten Ausgangssignale mittels der einzelnen Filterstränge der Filterschaltung bestimmt werden.

Der erste Filterstrang weist vorzugsweise einen ersten Eingangsreferenzwert, der zweite Filterstrang einen zweiten Eingangsreferenzwert und der dritte Filterstrang einen dritten Eingangsreferenzwert auf. Der erste Bereich wird mittels des ersten Eingangsreferenzwerts zugeordnet. Der zweite Bereich wird mittels des zweiten Eingangsreferenzwerts zugeordnet. Der dritte Bereich wird mittels des dritten Eingangsreferenzwerts zugeordnet.

In einer bevorzugten Ausführungsform wird mittels des ersten zweitstufigen Ausgangssignals, eines mittels des zweiten Filterstrangs erzeugten zweiten zweitstufigen Ausgangssignals, und eines mittels des dritten Filterstrang erzeugten dritten zweitstufigen Ausgangssignals ein Thermometerkode erzeugt. Das zeitdiskrete Ausgangssignal ist vorzugsweise ein zeitdiskreter Thermometerkode.

Es ist eine weitere Aufgabe der vorliegenden Erfindung, einen verbesserten Analog-Digital-Wandler zur Verfügung zu stellen.

Der Analog-Digital-Wandler umfasst vorzugsweise eine Filterschaltung, die in der zuvor geschilderten Weise einen zeitdiskreten Thermometerkode erzeugt. Der Analog-Digital-Wandler umfasst des Weiteren eine Übersetzungseinheit, wobei die Übersetzungseinheit eingerichtet ist, den zeitdiskreten Thermometerkode in ein zeitdiskretes binäres Ausgangssignal umzuwandeln.

Es ist eine weitere Aufgabe der vorliegenden Erfindung, ein verbessertes Verfahren zur Filterung von Signalen zur Verfügung zu stellen. Das Verfahren umfasst die Schritte:
- Umwandeln eines Eingangssignals in Abhängigkeit vom Wert des Eingangssignals in mindestens zwei unterscheidbare erste erststufige Ausgangssignale, wobei das Eingangssignal mit einem ersten Eingangsreferenzwert verglichen wird, um die ersten erststufigen Ausgangssignale zu bestimmen, wobei die ersten erststufigen Ausgangssignale dem Vorzeichen der Differenz des Eingangssignales minus des ersten Eingangsreferenzwert entsprechen,
- Integrieren der ersten erststufigen Ausgangssignale über einen vorgegebenen Zeitraum,
- Erzeugen eines ersten Integrationssignals basierend auf dem Ergebnis der Integration,
- Vergleichen des ersten Integrationssignals mit einem ersten Ausgangsreferenzwert, und
- Generieren eines ersten zweitstufigen Ausgangssignals basierend auf dem Ergebnis des Vergleichs.

Die einzelnen Schritte des Verfahrens müssen nicht notwendigerweise in der angegebenen Reihenfolge durchgeführt werden.

Es wird klargestellt, dass die Filterschaltung gemäß Anspruch 1, der Analog-Digital-Wandler gemäß Anspruch 13 und das Verfahren gemäß Anspruch 14 ähnliche und/oder identische Ausführungsform aufweisen, wie sie insbesondere in den abhängigen Ansprüchen beschrieben werden.

Es wird weiterhin klargestellt, dass bevorzugte Ausführungsformen der Erfindung auch jede Kombination der abhängigen Ansprüche mit dem entsprechenden unabhängigen Anspruch darstellen.

Weitere bevorzugte Ausführungsformen werden im Folgenden beschrieben.

### Kurze Beschreibung der Abbildungen

Diese und andere Aspekte der Erfindung werden im Detail in den Abbildungen wie folgt gezeigt.
Fig. 1 zeigt eine Prinzipskizze einer ersten Filterschaltung
Fig. 2 zeigt eine Prinzipskizze eines ersten Analog-Digital-Wandlers
Fig. 3 zeigt eine Prinzipskizze eines zweiten Analog-Digital-Wandlers
Fig. 4 zeigt eine Prinzipskizze eines Stranges eines dritten Analog-Digital-Wandlers
Fig. 5 zeigt eine Prinzipskizze eines Integrators einer Integrationsschaltung
Fig. 6 zeigt eine Prinzipskizze eines Verfahrens zur Filterung von Signalen

### Detaillierte Beschreibung der Ausführungsbeispiele

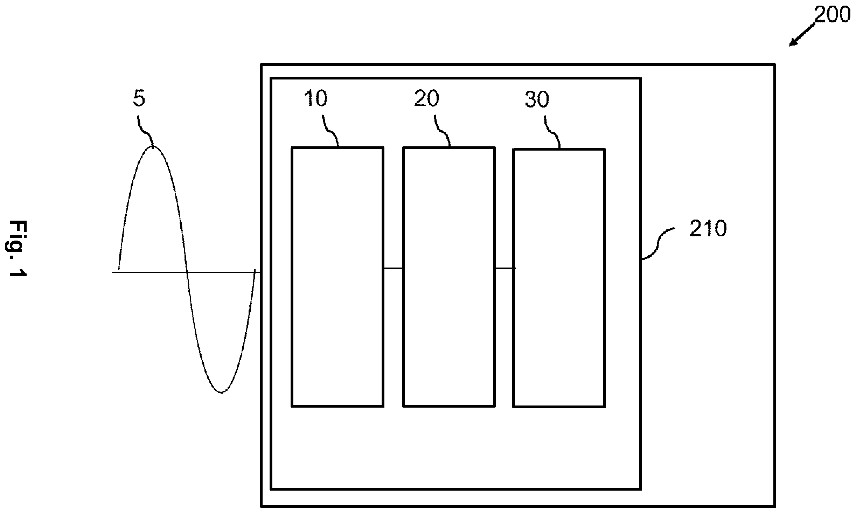

Fig. 1 zeigt eine Prinzipskizze einer ersten Filterschaltung 200. Die Filterschaltung 200 umfasst einen Filterstrang 210 mit einer Eingangsschaltung 10, einer Integrationsschaltung 20 und einer Ausgangsschaltung 30. Ein analoges Eingangssignal 5 wird durch die Eingangsschaltung 10 in erste erststufige Ausgangssignale umgewandelt, die das Eingangssignal 5 in einen definierten Bezug zu zum Beispiel einem definierten Eingangsreferenzwert 11, 12, 13, 14 setzen. Zielsetzung dieser Referenzierung des Eingangssignals 5 ist es, die ersten erststufigen Ausgangssignale durch den Bezug zu dem definierten Eingangsreferenzwert 11, 12, 13, 14 unterscheidbar zu machen. Diese Unterscheidbarkeit durch die Referenzierung ermöglicht in dieser Ausführungsform eine Integration der ersten erststufigen Ausgangssignale über einen vorgegebenen Zeitraum, so dass das Ergebnis der Integration einen eindeutigen Wert aufweist. Die Integration vermeidet, dass Veränderungen des Eingangssignals 5, insbesondere hochfrequente Störungen des Eingangssignals 5, die kürzer als der vorgegebene Zeitraum sind, keine bzw. nur einen geringfügigen Einfluss auf das Integrationsergebnis haben. Die ersten erststufigen Ausgangssignale können dabei diskreter Natur sein oder ein stetiges mittels des Eingangsreferenzwert 11, 12, 13 und 14 oder Referenzsignals referenziertes Abbild des Eingangssignals 5. Ein Beispiel für diskrete erste erststufige Ausgangssignale wären die definierten Spannungen am Ausgang eines Komparators, der vergleicht, ob das Eingangssignal 5 oberhalb oder unterhalb einer definierten Referenzspannung liegt. Die ersten erststufigen Ausgangssignale können kontinuierlich ausgegeben werden oder zeitdiskret. Bei einer zeitdiskreten Ausgabe der ersten erststufigen Ausgangssignale muss gewährleistet sein, dass mehrere mehrstufige Ausgangssignale (vorzugsweise mindestens 3) innerhalb des vorgegebenen Zeitraums erzeugt werden. Die Integrationsschaltung 20 empfängt die ersten erststufigen Ausgangssignale und integriert diese über den vorgegebenen Zeitraum. Die Integration kann dabei digital oder analog erfolgen. Bei einer digitalen Integration könnte zum Beispiel die Zahl von zeitdiskreten erststufigen Ausgangssignalen bei einer höheren Spannung und bei einer niedrigeren Spannung (zum Beispiel beim Ausgang eines Komparators) während des vorgegebenen Zeitraums bestimmt und voneinander subtrahiert werden. Bei einer analogen Integration könnte zum Beispiel eine Spannung bestimmt werden, die sich infolge einer durch die einstufigen Ausgangssignale erzeugten Ladungsverschiebung auf einem oder mehreren Kondensatoren ergibt. Die analoge Integration könnte den Vorteil haben, dass sie gegenüber kurzzeitigen Störungen des Eingangssignals 5 unempfindlicher ist. Des Weiteren würde die digitale Integration eine hohe Taktung der ersten erststufigen Ausgangssignale erforderlich machen, um eine zuverlässige Integration innerhalb des vorgegebenen Zeitraums durchführen zu können. Die Integrationsschaltung 20 erzeugt ein erstes Integrationssignal 25 basierend auf der Integration der ersten erststufigen Ausgangssignale und leitet das erste Integrationssignal 25 an die Ausgangsschaltung 30 weiter. Die Ausgangsschaltung 30 vergleicht das erste Integrationssignal 25 mit einem ersten Ausgangsreferenzwert und erzeugt ein erstes zweitstufiges Ausgangssignal 35.

Eine solche Filterschaltung 200 könnte insbesondere in Analog-Digital-Wandlern Anwendung finden. Im Unterschied zu herkömmlichen Analog-Digital-Wandlern würde das analoge Signal nicht zu einem einzigen Zeitpunkt zu einem digitalen Signal umgewandelt werden, wobei dieser Zeitpunkt zum Beispiel durch die Flanke eines Clocksignals vorgegeben wäre. Das analoge Signal würde vielmehr über einen vorgegebenen Zeitraum, der zum Beispiel einer Halbperiode des Clocksignals entsprechen könnte, integriert werden. Das Integrationssignal würde dann zur Erzeugung des digitalen Signals verwendet werden. Dies hätte den Vorteil, dass kurzzeitigen Schwankungen oder Störungen des Eingangssignals 5, die kürzer als eine Halbperiode des Clocksignals sind, einen deutlich verringerten Einfluss auf das Ergebnis der Digitalisierung haben würden. Die kurzzeitigen Schwankungen oder Störung des Eingangssignals 5 sind vorzugsweise kürzer als die Hälfte, ein Drittel, ein Fünftel oder zum Beispiel ein Zehntel des vorgegebenen Zeitraums (in diesem Fall eine Halbperiode des Clocksignals).

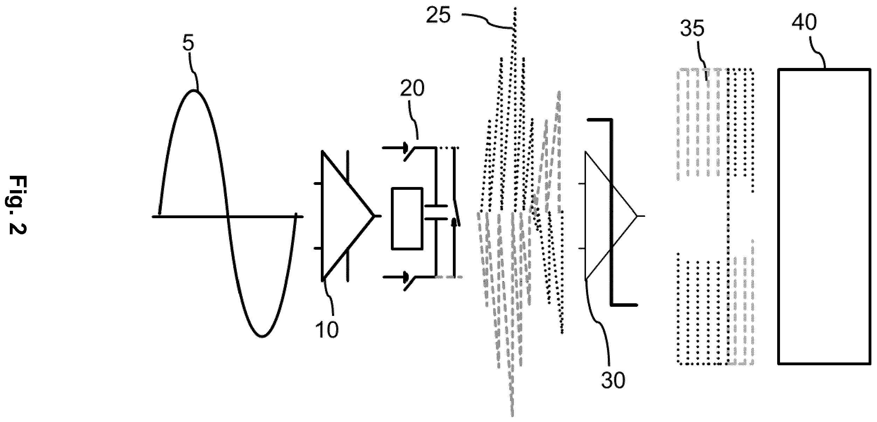

Fig. 2 zeigt eine Prinzipskizze ersten Analog-Digital-Wandlers. Es handelt sich bei dem Analog-Digital-Wandler um einen 1 Bit-Analog-Digital-Wandler, der eine Filterschaltung 200 mit einem Filterstrang 210 umfasst. Der Filterstrang 210 umfasst eine Eingangsschaltung 10, die als Gleichrichter ausgeführt ist, wobei der Gleichrichter einen Verstärker umfasst, der nicht gegengekoppelt ist. Der Gleichrichter gibt in Abhängigkeit vom Eingangssignal 5 und einem ersten Referenzsignal zwei unterschiedliche erste erststufige Ausgangssignale an eine Integrationsschaltung 20 des Filterstrangs 210 weiter. Die Integrationsschaltung 20 umfasst in einer einfachen Ausführungsform 3 Schalter und einen Kondensator. Zwei Schalter sind derart ausgeschaltet, dass das erste erststufige Ausgangssignal des Gleichrichters innerhalb einer ersten Halbperiode des Clocksignals auf den Kondensator weitergeleitet wird. Am Ende der ersten Halbperiode werden diese zwei Schalter geöffnet, so dass in einer zweiten Halbperiode des Clocksignals, das auf die erste Halbperiode folgt, keine Ladungen vom Gleichrichter an die Integrationsschaltung 20 weitergeleitet werden. Der Kondensator kann mittels des dritten Schalters kurzgeschlossen werden, so dass der Kondensator in der zweiten Halbperiode des Clocksignals wieder entladen werden kann. Die Integration erfolgt somit nur über den vorgegebenen Zeitraum, der hier durch die erste Halbperiode des Clocksignals gegeben ist. Die Ausgangsschaltung 30 ist als Komparator ausgeführt, der das Integrationssignal 25, das von der Integrationsschaltung 20 ausgegeben wird, mit einem zweiten Referenzsignal vergleicht und ein erstes zweitstufiges Ausgangssignal 35 ausgibt. Das erste zweitstufige Ausgangssignal 35 wird an eine Schaltung zur Zeitdiskreditierung 40 des Filterstrangs 210 weitergegeben. Die Schaltung zur Zeitdiskreditierung 40 ist in diesem Beispiel als getakteten Flipflop oder Latch ausgeführt. Das getakteten Flipflop gibt in Abhängigkeit vom ersten zweitstufigen Ausgangssignal 35 und dem durch das Clocksignal vorgegebenen Zeittakt ein zeitdiskretes Ausgangssignal 45 aus. Das zeitdiskret Ausgangssignal 45 kann im vorgegebenen Beispiel entweder den Wert 0 oder 1 annehmen, wobei die 1 einem ersten bestimmten Bereich der Amplitude des Eingangssignals 5 (zum Beispiel positive Halbwelle) und die 0 einem zweiten bestimmten Bereich der Amplitude des Eingangssignals 5 (zum Beispiel negative Halbwelle) zugeordnet ist. Das Eingangssignal 5 wird somit mittels des einen Filterstrangs 210 der Filterschaltung 200 in ein 1 Bit binäres Signal umgewandelt.

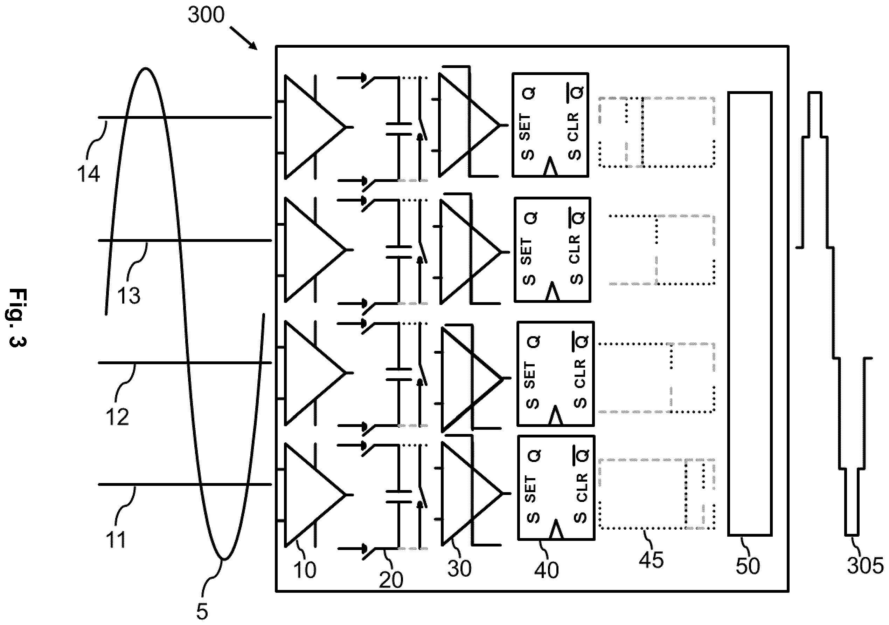

Fig. 3 zeigt eine Prinzipskizze eines zweiten Analog-Digital-Wandlers. Der Analog-Digital-Wandler weist eine Filterschaltung 200 mit vier Filtersträngen 210 auf. Jedem dieser Filterstränge 210 sind Eingangsreferenzwerte 11, 12, 13 und 14 zugeordnet, die es ermöglichen das Eingangssignal 5 bezüglich 4 verschiedener Eingangsreferenzwerte 11, 12, 13 und 14 zu referenzieren. Das Eingangssignal 5 wird somit in 5 verschiedene Bereiche aufgeteilt. Das Eingangssignal 5 wird parallel an alle Filterstränge 210 gegeben, wobei die Eingangsschaltungen 10 in Abhängigkeit vom jeweiligen Eingangsreferenzwert 11, 12, 13 oder 14 ein erstes erststufiges Ausgangssignal an die jeweilige Integrationsschaltung 20 weitergeben. Die Integrationsschaltungen 20 geben nun das jeweilige Integrationssignal 25 an den jeweiligen Filterstrang 210 zugehörige Ausgangsschaltung 30 weiter. Die Ausgangsschaltungen 30 erzeugen ein erstes, zweites, drittes und viertes zweitstufiges Ausgangssignal, das an die zum jeweiligen Filterstrang gehörige Schaltung zur Zeitdiskretisierung 40 weitergeleitet wird. Jeder der Schaltungen zur Zeitdiskretisierung 40 gibt ein zeitdiskretes Ausgangssignal 45 aus. In Abhängigkeit von der Amplitude des Eingangssignals 5 während des vorgegebenen Zeitraums und der Eingangsreferenzwerte 11, 12, 13 oder 14 gibt jede der Schaltungen zur Zeitdiskretisierung 40 mit dem zugehörigen Zeittakt des Clocksignals entweder den Wert 0 oder 1 aus. Werden den Eingangsreferenzwerten 11, 12, 13 oder 14 zum Beispiel aufsteigende Spannungswerte zugeordnet (-7,5V; -2,5V; 2,5V; 7,5V), so ergibt sich mittels der zeitdiskreten Ausgangssignale ein Thermometerkode (0000, 0001, 0011, 0111, 1111), der sich mittels einer Übersetzungseinheit 50 in ein zeitdiskretes binäres Ausgangssignal 305 übersetzen lässt. Die Übersetzungseinheit 50 könnte zum Beispiel mittels einer einfachen Zuordnungstabelle den jeweiligen Thermometerkode einer binären Zahl zuordnen (0000 -> 000, 0001 -> 001, 0011 -> 010, 0111 -> 011, 1111 -> 100).

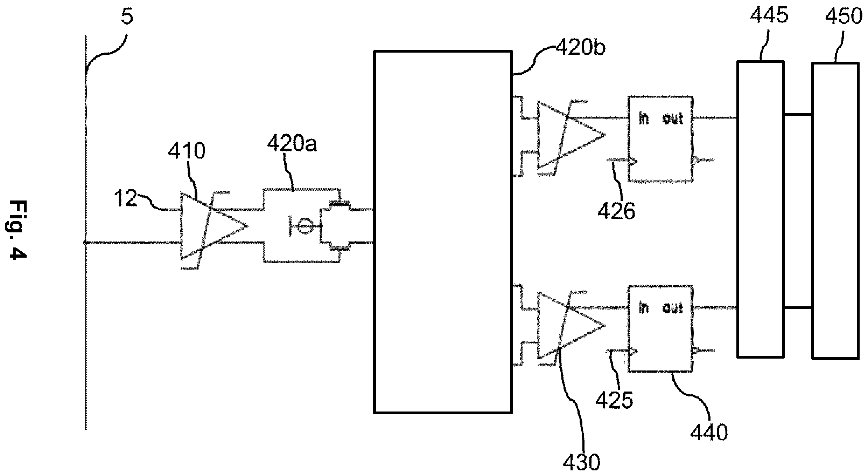

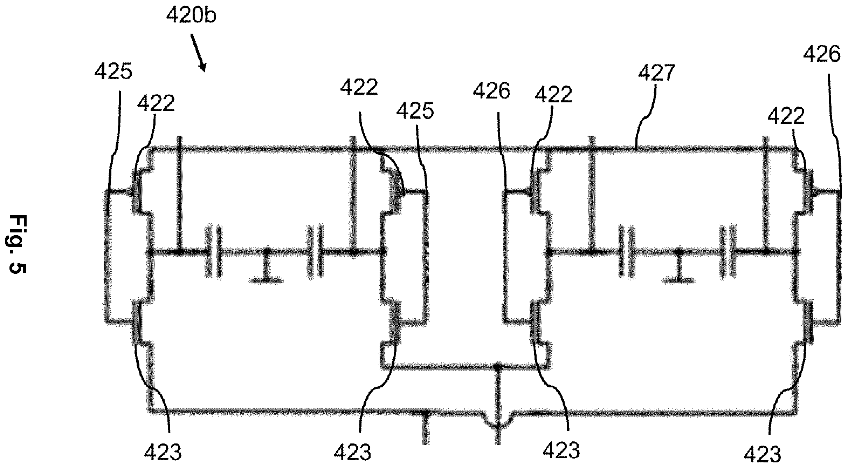

Fig. 4 zeigt eine Prinzipskizze eines zweiten Stranges eines dritten Analog-Digital-Wandlers. Der zweite Strang stellt eine mögliche konkrete Umsetzung des zweiten Strangs des in Fig. 3 gezeigten Analog-Digital-Wandlers dar. Die Eingangsschaltung 10 ist konkret als Eingangskomparator 410 ausgeführt, der das Eingangssignal 5 mit dem Eingangsreferenzwerte 12 vergleicht. Das erste erststufige Ausgangssignal des Eingangskomparators 410 wird an eine Differenzstufe 420a weitergeleitet, die wie Integrator 420b Teil der Integrationsschaltung 20 ist. Die Differenzstufe 420a wandelt das Spannungssignal des Eingangskomparators 410 in ein Stromsignal um, das von dem in Fig. 5 gezeigten Integrator 420b integriert werden kann. Der Integrator 420 b weist zwei Zweige auf, wobei jeder Zweig zwei Kondensatoren umfasst. Ein Zweig wird dabei in der Halbperiode des Clocksignals geladen, in der das Clocksignal high 425 ist. Der andere Zweig wird in der Halbperiode geladen, in der das Clocksignal low 426 ist. Dies erfolgt mittels der in Fig. 5 dargestellten Anordnung von selbstsperrenden Transistoren 422 und selbstleitenden Transistoren 423, die in Abhängigkeit vom Clocksignal (high oder low) die Kondensatoren des ersten oder zweiten Zweigs entweder laden oder entladen. Die Ladung auf den Kondensatoren wird mittels zweier Ausgangskomparatoren 430, die von der Ausgangsschaltung 30 umfasst sind bestimmt. Ein Ausgangskomparator 430 ist dabei dem ersten Zweig und ein anderer dem zweiten Zweig des Integrators 420b zugeordnet. Die Ausgänge der beiden Ausgangskomparatoren 430 werden wiederum auf einen zugehörigen Eingang einer zugeordneten Schaltung zur Zeitdiskretisierung 440 weitergeleitet. Der Ausgang des dem ersten Zweig des Integrators 420 b zugeordneten Ausgangskomparators 430 (unterer Teil in der Fig. 4 bzw. rechter Teil in der Fig. 5) wird somit auf einen Eingang eines ersten getakteten Flipflops weitergegeben. Das erste getakteten Flipflop wird durch das Clocksignal low 426 getaktet. Der Ausgang des dem zweiten Zweig des Integrators 420b zugeordneten Ausgangskomparators 430 (oberer Teil in der Fig. 4 bzw. linker Teil in der Fig. 5) wird auf einen Eingang eines zweiten getakteten Flipflops weitergegeben. Das zweite getakteten Flipflop wird durch das Clocksignal high 426 getaktet. Die zwei Zweige des Integrators 420b in Kombination mit den zwei Ausgangskomparatoren 430 der Ausgangsschaltung 30 und den jeweils zugeordneten getakteten Flipflops der Schaltung zur Zeitdiskretisierung 440 ermöglichen es, das Eingangssignal 5 während beider Halbperioden des Clocksignals zu in diesem Fall zweiten (zweiter Filterstrang mit Eingangsreferenzwerte 12) zeitdiskreten Ausgangssignalen 45 umzuwandeln. Ein Multiplexer 445 wird sodann verwendet um die zeitdiskreten Ausgangssignale 45 der zwei Zweige zu einem zweiten zeitdiskreten Ausgangssignal zusammenzufügen und zusammen mit den ersten, dritten und vierten zeitdiskreten Ausgangssignal an einer Übersetzungseinheit 450 weiterzuleiten. Die Übersetzungseinheit 450 wandelt dabei den Thermometerkode, wie zuvor diskutiert, in ein zeitdiskretes binäres Ausgangssignal 305 um. Der Multiplexer 445 kann in einer alternativen Ausführungsform auch hinter der Übersetzungseinheit 450 angebracht sein, so dass die zeitdiskreten Ausgangssignale der zwei Zweige des jeweiligen Strangs (oder Filterstrangs 210) zuerst mittels der Übersetzungseinheit 450 digitalisiert werden und erst anschließend durch den Multiplexer 445 zu einem zeitdiskreten binären Ausgangsignal 305 zusammengesetzt werden. Die Anzahl der Filterstränge 210 bzw. Stränge des Analog-Digital-Wandlers wird in Abhängigkeit davon gewählt, welche Auflösung das zeitdiskrete binäre Ausgangssignal 305 in Bezug auf das Eingangssignal 5 ermöglichen soll.

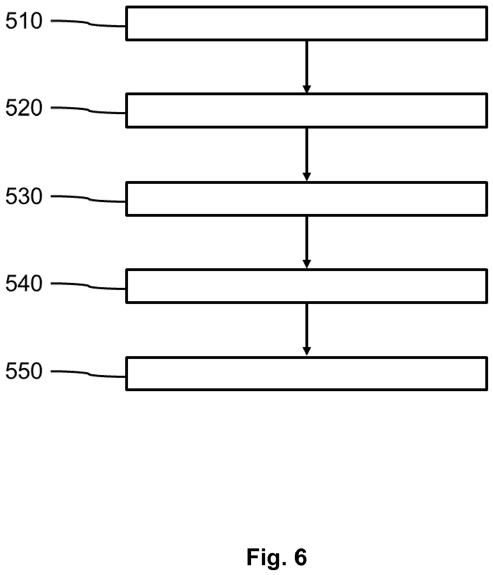

Fig. 6 zeigt eine Prinzipskizze eines Verfahrens zur Filterung von Signalen. In Schritt 510 wird ein analoges Eingangssignal 5 in Abhängigkeit vom Wert des Eingangssignals 5 in mindestens zwei unterscheidbare erste erststufige Ausgangssignale umgewandelt. In Schritt 520 wird das oder werden die erststufigen Ausgangssignale über einen vorgegebenen Zeitraum integriert. In Schritt 530 wird ein erstes Integrationssignal 25 basierend auf dem Ergebnis der Integration erzeugt. In Schritt 540 erfolgt ein Vergleich des ersten Integrationssignals 25 mit einem ersten Ausgangsreferenzwert oder Ausgangsreferenzsignal. In Schritt 550 wird basierend auf dem Ergebnis des Vergleichs in Schritt 540 ein erstes zweitstufiges Ausgangssignal 35 erzeugt.

Es ist eine Idee der vorliegenden Erfindung ein Eingangssignal 5 über einen vorgegebenen Zeitraum zu integrieren, und das Ergebnis der Integration in ein zeitdiskretes Ausgangssignal 45 umzuwandeln. Das zeitdiskrete Ausgangssignal 45 kann wiederum in ein zeitdiskretes binäres Ausgangssignal 305 umgewandelt werden. Ein Einfluss von im Vergleich zum vorgegebenen Zeitraum höherfrequenten Schwankungen oder Störungen auf zum Beispiel die Digitalisierung von analogen Eingangssignalen 5 könnte somit vermindert werden, da die Digitalisierung des Eingangssignals nicht mehr von einem momentanen Wert des Eingangssignals 5 abhängt.

Eine entsprechend angepasste Filterschaltung kann zum Beispiel in einem Analog-Digital-Wandler (ADC) verwendet werden. Der ADC arbeitet in drei Stufen:
1) Wertdiskretisierung: Das Eingangssignal wird mit Hilfe von zum Beispiel n-1 Verstärkern (Gleichrichter) für n Bits kontinuierlich digitalisiert. Das Ausgangsignal der Verstärker entspricht dem Vorzeichen des Eingangssignales minus des jeweiligen Referenzwertes. Auf diese Weise entsteht nach den Verstärkern ein kontinuierlicher Thermometerkode des Eingangssignales.
2) periodische Integration: Jedes Bit des Thermometerkodes wird für sich über eine Halbperiode eines Clocksignals integriert. Das Ausgangssignal der Integrationsschaltung ist das Vorzeichen ob das jeweilige Bit des Thermometerkodes während der Halbperiode öfter -1 oder +1 war.
3) Zeitdiskretisierung: Am Ende der Halbperiode erfasst ein getakteter Verstärker ob das Ausgangsignal der Integrationsschaltung am Ende des Integrationszeitraumes -1 oder +1 ist.
4) Konvertierung: Das zeitdiskreditierte Ausgangssignal wird nach dem Abtasten vom Thermometerkode in binären Kode konvertiert.

Weitere Varianten der Erfindung und ihre Ausführung ergeben sich für den Fachmann aus der vorangegangenen Offenbarung, den Figuren und den Patentansprüchen.

In den Patentansprüchen verwendete Begriffe wie "umfassen", "aufweisen", "beinhalten", "enthalten" und dergleichen schließen weitere Elemente oder Schritte nicht aus. Die Verwendung des unbestimmten Artikels schließt eine Mehrzahl nicht aus. Eine einzelne Einrichtung kann die Funktionen mehrerer in den Patentansprüchen genannten Einheiten bzw. Einrichtungen ausführen. In den Patentansprüchen angegebene Bezugszeichen sind nicht als Beschränkungen der eingesetzten Mittel und Schritte anzusehen.

### Liste der Bezugszeichen

- 5: Eingangssignal
- 10: Eingangsschaltung
- 11, 12, 13, 14: Eingangsreferenzwert
- 20: Integrationsschaltung
- 25: Integrationssignal
- 30: Ausgangsschaltung
- 35: zweitstufiges Ausgangssignal
- 40, 440: Schaltung zur Zeitdiskreditierung
- 45: zeitdiskretes Ausgangssignal
- 50, 450: Übersetzungseinheit
- 200: Filterschaltung
- 210: Filterstrang
- 300: Analog-Digital-Wandler
- 305: zeitdiskretes binäres Ausgangssignal
- 410: Eingangskomparator
- 420a: Differenzstufe
- 420b: Integrator
- 422: selbstsperrender Transistor
- 423: selbstleitender Transistor
- 425: Clock high
- 426: Clock low
- 427: Versorgungsspannung
- 430: Ausgangskomparator
- 445: Multiplexer
- 510: Umwandeln eines analogen Eingangssignals
- 520: Integrieren von erststufigen Ausgangssignalen
- 530: Erzeugen eines Integrationssignals
- 540: Vergleich Integrationssignal Ausgangsreferenzwert
- 550: Generieren eines zweitstufigen Ausgangssignals

## Patentansprüche

1. Eine Filterschaltung (200) umfassend mindestens einen ersten Filterstrang (210), wobei der erste Filterstrang (210) eine erste Eingangsschaltung (10), eine erste Integrationsschaltung (20) und eine erste Ausgangsschaltung (30) aufweist, wobei der erste Filterstrang (210) einen ersten Eingangsreferenzwert (11, 12, 13, 14) aufweist, wobei die erste Eingangsschaltung (10) eingerichtet ist, ein Eingangssignal (5) in Abhängigkeit vom Wert des Eingangssignals in mindestens zwei unterscheidbare, erste erststufige Ausgangssignale umzuwandeln, wobei das Eingangssignal mit dem ersten Eingangsreferenzwert (11, 12, 13, 14) verglichen wird, um die ersten erststufigen Ausgangssignale zu bestimmen, wobei die ersten erststufigen Ausgangssignale einem Vorzeichen der Differenz des Eingangssignales (5) minus des ersten Eingangsreferenzwertes (11, 12, 13, 14) entsprechen, wobei die erste Eingangsschaltung (10) weiter eingerichtet ist, die erststufigen Ausgangssignale während eines vorgegebenen Zeitraums an die erste Integrationsschaltung (20, 420) weiterzuleiten, wobei die erste Integrationsschaltung (20) eingerichtet ist, die ersten erststufigen Ausgangssignale der ersten Eingangsschaltung (10) über den vorgegebenen Zeitraum zu integrieren und ein erstes Integrationssignal (25) zu erzeugen, und wobei die erste Ausgangsschaltung (30) eingerichtet ist, das erste Integrationssignal (25) mit einem ersten Ausgangreferenzwert zu vergleichen und ein erstes zweitstufiges Ausgangssignal (35) zu generieren.

2. Die Filterschaltung (200) gemäß einem der vorangehenden Ansprüche, wobei die erste Eingangsschaltung (10) zumindest einen Eingangskomparator (410) und die erste Ausgangsschaltung (30) zumindest einen Ausgangskomparator (430) aufweist.

3. Die Filterschaltung (200) gemäß einem der vorangehenden Ansprüche, wobei die erste Integrationsschaltung (20) zumindest einen ersten Kondensator und erste Schalter aufweist, wobei der erste Kondensator und die ersten Schalter eingerichtet sind, elektrische Ladungen, die den ersten erststufigen Ausgangssignalen zugeordnet sind, über den vorgegebenen Zeitraum zu akkumulieren.

4. Die Filterschaltung (200) gemäß einem der vorangehenden Ansprüche, wobei der vorgegebene Zeitraum durch ein erstes regelmäßiges Zeitsignal vorgegeben wird.

5. Die Filterschaltung (200) gemäß einem der vorangehenden Ansprüche, wobei der erste Filterstrang (210) eine erste Schaltung zur Zeitdiskreditierung (40, 440) aufweist, und die erste Schaltung zur Zeitdiskreditierung (40, 440) eingerichtet ist, das erste zweitstufige Ausgangssignal zu verarbeiten und ein zeitdiskretes Ausgangssignal (45) zu erzeugen.

6. Die Filterschaltung (200) gemäß Anspruch 5, sofern Anspruch 5 auf Anspruch 4 zurückbezogen ist, wobei die erste Schaltung zur Zeitdiskreditierung (40, 440) eingerichtet ist, das erste zweitstufige Ausgangssignal (35) in Abhängigkeit von dem ersten regelmäßigen Zeitsignal in das erste zeitdiskrete Ausgangssignale (45) umzuwandeln.

7. Die Filterschaltung (200) gemäß einem der vorangehenden Ansprüche, wobei die Filterschaltung mindestens einen zweiten Filterstrang (210) aufweist, wobei dem ersten Filterstrang (210) ein erster Bereich des Eingangssignals zugeordnet ist und dem zweiten Filterstrang (210) ein zweiter Bereich des Eingangssignals (5) zugeordnet ist, wobei sich der erste Bereich des Eingangssignals (5) vom zweiten Bereich des Eingangssignals (5) unterscheidet.

8. Die Filterschaltung (200) gemäß Anspruch 7, weiter umfassend mindestens einen dritten Filterstrang (210), wobei dem dritten Filterstrang (210) ein dritter Bereich des Eingangssignals (5) zugeordnet ist, wobei der zweite Bereich des Eingangssignals (5) an den ersten Bereich des Eingangssignals (5) grenzt, und der dritte Bereich des Eingangssignals (5) an den zweiten Bereich des Eingangssignals (5) grenzt.

9. Die Filterschaltung (200) gemäß Anspruch 8, sofern der Anspruch 8 auf die Ansprüche 1 bis 7 zurückbezogen sind, wobei der zweite Filterstrang (210) einen zweiten Eingangsreferenzwert (11, 12, 13 ,14) und der dritte Filterstrang (210) einen dritten Eingangsreferenzwert (11, 12, 13 ,14) aufweist, wobei der erste Bereich mittels des ersten Eingangsreferenzwerts (11, 12, 13 ,14) zugeordnet wird, der zweite Bereich mittels des zweiten Eingangsreferenzwerts (11, 12, 13 ,14) zugeordnet wird und der dritte Bereich mittels des dritten Eingangsreferenzwerts (11, 12, 13 ,14) zugeordnet wird.

10. Die Filterschaltung (200) gemäß einem der Ansprüche 8 oder 9, wobei mittels des ersten zweitstufigen Ausgangssignals (35), eines mittels des zweiten Filterstrangs (210) erzeugten zweiten zweitstufigen Ausgangssignals (35), und eines mittels des dritten Filterstrang (210) erzeugten dritten zweitstufigen Ausgangssignals (35) ein Thermometerkode erzeugt wird.

11. Ein Analog-Digital-Wandler umfassend die Filterschaltung (200) gemäß Anspruch 10 und einen Übersetzungseinheit (50), wobei die Übersetzungseinheit (50) eingerichtet ist, den zeitdiskreten Thermometerkode in ein zeitdiskretes binäres Ausgangssignal (305) umzuwandeln.

12. Ein Verfahren zur Filterung von Signalen umfassend die Schritte:
- Umwandeln eines Eingangssignals (5) in Abhängigkeit vom Wert des Eingangssignals (5) in mindestens zwei unterscheidbare erste erststufige Ausgangssignale, wobei das Eingangssignal mit einem ersten Eingangsreferenzwert (11, 12, 13, 14) verglichen wird, um die ersten erststufigen Ausgangssignale zu bestimmen, wobei die ersten erststufigen Ausgangssignale einem Vorzeichen der Differenz des Eingangssignales (5) minus des ersten Eingangsreferenzwertes (11, 12, 13, 14) entsprechen,
- Integrieren der ersten erststufigen Ausgangssignalen über einen vorgegebenen Zeitraum,
- Erzeugen eines ersten Integrationssignals (25) basierend auf dem Ergebnis der Integration,
- Vergleichen des ersten Integrationssignals (25) mit einem ersten Ausgangsreferenzwert, und
- Generieren eines ersten zweitstufigen Ausgangssignals (35) basierend auf dem Ergebnis des Vergleichs.

## Claims

1. A filter circuit (200) comprising at least a first filter line (210), wherein the first filter line (210) comprises a first input circuit (10), a first integration circuit (20) and a first output circuit (30), wherein the first filter line (210) comprises a first input reference value (11, 12, 13, 14), wherein the first input circuit (10) is configured in such a way that, as a function of the value of the input signal, it converts an input signal (5) into at least two distinguishable, first first-stage output signals, wherein the input signal is compared to the first input reference value (11, 12, 13, 14) to determine the first first-stage output signals, wherein the first first-stage output signals correspond to a mathematical sign of the difference of the input signal (5) minus the first input reference value (11, 12, 13, 14), wherein the first input circuit (10) is further configured to relay the first-stage output signals to the first integration circuit (20, 420) during a predefined period of time, wherein the first integration circuit (20) is configured to integrate the first first-stage output signals of the first input circuit (10) over the predefined period of time and to generate a first integration signal (25), and wherein the first output circuit (30) is configured to compare the first integration signal (25) to a first output reference value and to generate a first second-stage output signal (35).

2. The filter circuit (200) according to any one of the preceding claims, wherein the first input circuit (10) comprises at least an input comparator (410) and the first output circuit (30) comprises at least an output comparator (430).

3. The filter circuit (200) according to any one of the preceding claims, wherein the first integration circuit (20) comprises at least a first capacitor and first switches, wherein the first capacitor and the first switches are configured so that, over the predefined period of time, they accumulate electric charges that are associated with the first first-stage output signals.

4. The filter circuit (200) according to any one of the preceding claims, wherein the predefined period of time is predefined by a first regular time signal.

5. The filter circuit (200) according to any one of the preceding claims, wherein the first filter line (210) comprises a first circuit for time discretization (40, 440), and wherein the first circuit for the time discretization (40, 440) is configured to process the first second-stage output signal and to generate a time-discrete output signal (45).

6. The filter circuit (200) according to claim 5 to the extent that claim 5 refers back to claim 4, wherein the first circuit for the time discretization (40, 440) is configured to convert the first second-stage output signal (35) into the first time-discrete output signal (45) as a function of the first regular time signal.

7. The filter circuit (200) according to any one of the preceding claims, wherein the filter circuit comprises at least a second filter line (210), wherein a first range of the input signal is associated with the first filter line (210), and wherein a second range of the input signal (5) is associated with the second filter line (210), wherein the first range of the input signal (5) differs from the second range of the input signal (5).

8. The filter circuit (200) according to claim 7, further comprising at least a third filter line (210), wherein a third range of the input signal (5) is associated with the third filter line (210), wherein the second range of the input signal (5) adjoins the first range of the input signal (5), and the third range of the input signal (5) adjoins the second range of the input signal (5).

9. The filter circuit (200) according to claim 8 to the extent that claim 8 refers back to the claims 1 to 7, wherein the second filter line (210) comprises a second input reference value (11, 12, 13, 14), and wherein the third filter line (210) comprises a third input reference value (11, 12, 13, 14), wherein the first range is associated by means of the first input reference value (11, 12, 13, 14), the second range is associated by means of the second input reference value (11, 12, 13, 14), and the third range is associated by means of the third input reference value (11, 12, 13, 14).

10. The filter circuit (200) according to one of the claims 8 or 9, wherein a thermometer code is generated by means of the first second-stage output signal (35), by means of a second second-stage output signal (35) generated by the second filter line (210), and by means of a third second-stage output signal (35) generated by the third filter line (210).

11. An analog-to-digital converter comprising a filter circuit (200) according to claim 10 and a transformation unit (50), wherein the transformation unit (50) is configured to convert the time-discrete thermometer code into a time-discrete binary output signal (305).

12. A method for filtering signals, comprising the following steps:
- converting an input signal (5), as a function of the value of the input signal (5), into at least two distinguishable first first-stage output signals, wherein the input signal is compared to a first input reference value (11, 12, 13, 14) to determine the first first-stage output signals, wherein the first first-stage output signals correspond to a mathematical sign of the difference of the input signal (5) minus the first input reference value (11, 12, 13, 14);
- integrating the first first-stage output signals over a predefined period of time;
- generating a first integration signal (25) on the basis of the result of the integration;
- comparing the first integration signal (25) to a first output reference value; and
- generating a first second-stage output signal (35) on the basis of the result of the comparison.

## Revendications

1. Circuit filtrant (200), comprenant au moins un premier tronçon filtrant (210), dans lequel le premier tronçon filtrant (210) comporte un premier circuit d'entrée (10), un premier circuit d'intégration (20) et un premier circuit de sortie (30), le premier tronçon filtrant (210) présentant une première valeur de référence d'entrée (11, 12, 13, 14), le premier circuit d'entrée (10) étant agencé pour convertir un signal d'entrée (5), en fonction de la valeur du signal d'entrée, en au moins deux premiers signaux de sortie de premier étage distincts, le signal d'entrée étant comparé à la première valeur de référence d'entrée (11, 12, 13, 14) pour définir les premiers signaux de sortie de premier étage distincts, les premiers signaux de sortie de premier étage distincts correspondant à un signe de la différence du signal d'entrée (5) moins la première valeur de référence d'entrée (11, 12, 13, 14), le premier circuit d'entrée (10) étant également agencé pour transférer les signaux de sortie de premier étage pendant une période prédéfinie au premier circuit d'intégration (20, 420), le premier circuit d'intégration (20) étant agencé pour intégrer les premiers signaux de sortie de premier étage du premier circuit d'entrée (10) dans le cadre de la période prédéfinie et pour produire un premier signal d'intégration (25), et le premier circuit de sortie (30) étant agencé pour comparer le premier signal d'intégration (25) à une première valeur de référence de sortie et pour générer un premier signal de sortie de deuxième étage (35).

2. Circuit filtrant (200) selon l'une des revendications précédentes, dans lequel le premier circuit d'entrée (10) comporte au moins un comparateur d'entrée (410), et le premier circuit de sortie (30) comportant au moins un comparateur de sortie (430).

3. Circuit filtrant (200) selon l'une des revendications précédentes, dans lequel le premier circuit d'intégration (20) comporte au moins un premier condensateur et des premiers commutateurs, le premier condensateur et les premiers commutateurs étant agencés pour, dans le cadre de la période prédéfinie, accumuler des charges électriques qui sont affectées aux premiers signaux de sortie de premier étage.

4. Circuit filtrant (200) selon l'une des revendications précédentes, dans lequel la période prédéfinie est prédéfinie par un premier signal horaire régulier.

5. Circuit filtrant (200) selon l'une des revendications précédentes, dans lequel le premier tronçon filtrant (210) comporte un premier circuit de discrétisation temporelle (40, 440), et le premier circuit de discrétisation temporelle (40, 440) est agencé pour traiter le premier signal de sortie de deuxième étage et produire un signal de sortie (45) discret dans le temps.

6. Circuit filtrant (200) selon la revendication 5, dans la mesure où la revendication 5 fait référence à la revendication 4, dans lequel le premier circuit de discrétisation temporelle (40, 440) est agencé pour convertir en premier signal de sortie (45) discret dans le temps le premier signal de sortie de deuxième étage (35) en fonction du premier signal horaire régulier.

7. Circuit filtrant (200) selon l'une des revendications précédentes, dans lequel le circuit filtrant comprend au moins un deuxième tronçon filtrant (210), une première plage du signal d'entrée étant affectée au premier tronçon filtrant (210), et une deuxième plage du signal d'entrée (5) étant affectée au deuxième tronçon filtrant (210), la première plage du signal d'entrée (5) étant différente de la deuxième plage du signal d'entrée (5).

8. Circuit filtrant (200) selon la revendication 7, comprenant également au moins un troisième tronçon filtrant (210), une troisième plage du signal d'entrée (5) étant affectée au troisième tronçon filtrant (210), la deuxième plage du signal d'entrée (5) étant adjacente à la première plage du signal d'entrée (5), et la troisième plage du signal d'entrée (5) étant adjacente à la deuxième plage du signal d'entrée (5).

9. Circuit filtrant (200) selon la revendication 8, dans la mesure où la revendication 8 fait référence aux revendications 1 à 7, dans lequel le deuxième tronçon filtrant (210) comporte une deuxième valeur de référence d'entrée (11, 12, 13, 14), et le troisième tronçon filtrant (210) comporte une troisième valeur de référence d'entrée (11, 12, 13, 14), la première plage étant affectée au moyen de la première valeur de référence d'entrée (11, 12, 13, 14), la deuxième plage étant affectée au moyen de la deuxième valeur de référence d'entrée (11, 12, 13, 14) et la troisième plage étant affectée au moyen de la troisième valeur de référence d'entrée (11, 12, 13, 14).

10. Circuit filtrant (200) selon l'une des revendications 8 ou 9, dans lequel un code thermomètre est produit au moyen du premier signal de sortie de deuxième étage (35), d'un deuxième signal de sortie de deuxième étage (35) produit au moyen du deuxième tronçon filtrant (210) et d'un troisième signal de sortie de deuxième étage (35) produit au moyen du troisième tronçon filtrant (210).

11. Convertisseur analogique-numérique, comprenant le circuit filtrant (200) selon la revendication 10 et une unité de transformation (50), l'unité de transformation (50) étant agencée pour convertir le code thermomètre discret dans le temps en un signal de sortie (305) binaire discret dans le temps.

12. Procédé de filtrage de signaux, comprenant les étapes suivantes :
- conversion d'un signal d'entrée (5) en fonction de la valeur du signal d'entrée (5) en au moins deux premier signaux de sortie de premier étage distincts, le signal d'entrée étant comparé à une première valeur de référence d'entrée (11, 12, 13, 14) pour définir les premiers signaux de sortie de premier étage, les premiers signaux de sortie de premier étage correspondant à un signe de la différence du signal d'entrée (5) moins la première valeur de référence d'entrée (11, 12, 13, 14),
- intégration des premiers signaux de sortie de premier étage dans le cadre d'une période prédéfinie,
- production d'un premier signal d'intégration (25) sur la base du résultat de l'intégration,
- comparaison du premier signal d'intégration (25) à une première valeur de référence de sortie, et
- génération d'un premier signal de sortie de deuxième étage (35) sur la base du résultat de la comparaison.
